# DEMANDE DE BREVET EUROPEEN

(11) **EP 0 723 163 A1**
(43) Date de publication de la demande: **24.07.1996**
(21) Numéro de dépôt: 96400105.1
(22) Date de dépôt: 16.01.1996
(51) Int. Cl.: G01R 31/28

(54) **Procédé et système de contrôle de cartes de circuits imprimés avant le report de composants sur les cartes**

(30) Priorité: 17.01.1995 FR 9500449
(71) Demandeur: THOMSON-CSF, 75008 Paris (FR)
(72) Inventeur: Merillac, Pascal, f-92402 Courbevoie Cedex (FR); Gobil, Dominique, f-92402 Courbevoie Cedex (FR)
(74) Mandataire: Lincot, Georges

(57) **Abrégé**

L'invention concerne un procédé de contrôle de cartes de circuits imprimés, avant le report de composants sur les cartes, consistant à amener les sondes (2₁ à 2₃) d'un testeur (6), utilisé habituellement pour le test des cartes équipées de composants, en contact avec des plages métallisées (3₁ à 3₃) aménagées sur une première face (9) de la carte et couplées à au moins un noeud du circuit imprimé sur la première face (9) de la carte (1), caractérisé en ce qu'il consiste à recouvrir provisoirement la face (8) opposée à la première face (9) recevant les sondes (2₁ à 2₃) d'une couche conductrice (10) permettant d'assurer une liaison électrique entre chacun des noeuds du circuit imprimé sur la carte (1), et après avoir vérifié par le testeur (6) que les plages (3₁ à 3₃) sont en contact avec les sondes (2₁ à 2₃) et qu'il n'y a pas de courts-circuits entre les plages (3₁ à 3₃), à retirer la couche conductrice (10) avant le report des composants sur la carte (1).

Application : test de cartes de circuits imprimés nues en phase prototype.

## Description

L'invention concerne un procédé et un système de contrôle de cartes de circuits imprimés, avant le report de composants sur les cartes. Le domaine technique dans lequel s'appliquent le procédé et le système selon l'invention est celui du test des cartes électroniques et plus particulièrement des cartes électroniques nues prototypes.

Devant l'augmentation de la complexité des cartes électroniques, des technologies mises en oeuvre (CMS : abréviation pour "Composants Montés en Surface", et haute densité), il est devenu indispensable de tester la carte de circuit imprimé nue avant son équipement afin de déceler d'éventuels défauts de fabrication tels que des courts-circuits et de s'assurer de sa testabilité (son aptitude à être testé après report des composants sur la carte). Cette testabilité doit être prise en compte dès le début de la conception de la carte qui doit préciser toutes les contraintes de fabrication ainsi que les accès aux différents noeuds du circuit. Ces différents noeuds correspondent au point commun entre plusieurs connexions ayant le même potentiel. Ces noeuds sont appelés également "équipotentielles". Une équipotentielle est matérialisée par une pastille de cuivre gravée sur le circuit appelée également "plage de test".

Pour le test des cartes de circuits imprimés nues, deux types de testeurs spécifiques connus sont utilisés :
- un premier type de testeur, dénommé testeur non multiplexé, comporte un nombre important de canaux de mesure, chaque canal étant couplé respectivement à une pointe de test appartenant à une interface personnalisée spécifique à la carte à tester,
- un deuxième type de testeur, appelé testeur multiplexé, comporte une ou plusieurs sondes mobiles commandées à l'aide d'un programme spécifique à la carte à tester.

Les délais de fabrication très courts imposés aux fournisseurs de cartes de circuits imprimés en phase prototype, font que les moyens de test des cartes de circuits imprimés nues ne sont pas toujours réalisés à temps pour tester les premières cartes.

Le risque est alors important de trouver une carte de circuit imprimé présentant des défauts. Il est évident qu'il est plus facile de corriger le défaut avant le report des composants sur la carte qu'après. Il peut arriver de jeter une carte équipée sur laquelle un court-circuit n'a pu être localisé et réparé.

Le but de l'invention est de pallier les inconvénients précités.

A cet effet, l'invention a pour objet un procédé de contrôle de cartes de circuits imprimés, avant le report de composants sur les cartes, consistant à amener les sondes d'un testeur, utilisé habituellement pour le test des cartes équipées de composants, en contact avec des plages aménagées sur une première face de la carte et couplées à au moins un noeud du circuit imprimé sur la première face, caractérisé en ce qu'il consiste à recouvrir provisoirement la face opposée à la première face recevant les sondes d'une couche conductrice permettant d'assurer une liaison électrique entre chacun des noeuds du circuit imprimé sur la carte, et après avoir vérifié par le testeur que les plages sont en contact avec les sondes et qu'il n'y a pas de courts-circuits entre les plages, à retirer la couche conductrice avant le report des composants sur la carte.

L'invention a également pour objet un système de contrôle de cartes de circuits imprimés, avant le report de composants sur les cartes, comportant un dispositif de test de cartes équipées de composants, muni de sondes destinées à être amenées lors du test en contact avec des plages métallisées aménagées sur une première face de la carte et couplées à au moins un noeud du circuit imprimé sur la première face, caractérisé en ce que la face opposée à la première face de la carte recevant les sondes, est recouverte d'une couche conductrice destructible, permettant d'assurer une liaison électrique provisoire entre chacun des noeuds du circuit imprimé sur la carte.

La présente invention apporte donc une solution pour assurer rapidement et sans investir de moyens spécifiques coûteux, la vérification des cartes de circuits imprimés en phase prototype. Les avantages de la présente invention sont multiples :
- les problèmes non repérables sur la carte de circuit imprimé sont vus avant l'implantation des composants,
- si la carte est considérée bonne, sa testabilité une fois équipée de composants est assurée,
- un gain en termes de coût et de délai est obtenu sur la fabrication de la carte, et
- une validation de l'interface de test avant que la carte ne soit câblée est ainsi effectuée.

Le système selon l'invention utilise les mêmes outillages aussi bien pour le test des cartes de circuits imprimés nues que pour celui des cartes équipées de composants appelé également "test in situ".

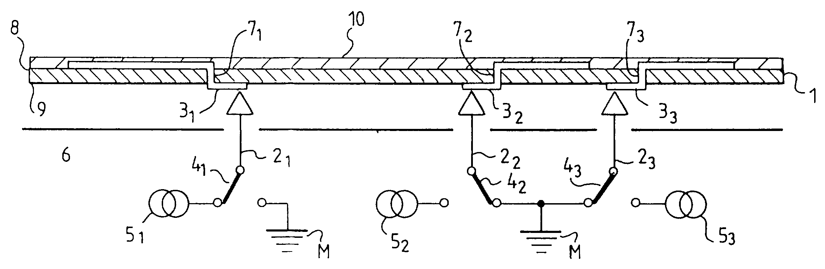

D'autres avantages et caractéristiques de l'invention apparaîtront plus clairement ci-après à l'aide de la description faite en regard de la figure unique qui suit et qui représente un schéma de principe du procédé selon l'invention.

Le procédé selon l'invention est mis en oeuvre à partir d'un testeur, équipement habituellement utilisé pour appliquer des stimuli à un élément électronique et vérifier qu'en sortie les résultats attendus sont corrects ou non. Ce testeur effectue un test in situ. Cet équipement de test permet donc le test des interconnexions gravées sur une carte de circuit imprimé équipée de ses composants.

Ce test se fait à travers une matrice de pointes disposées au pas de grille de la carte ; cette matrice est également appelée "planche à clous". Cette matrice spécifique à la carte assure ainsi l'interface de test entre la carte et le testeur. Cette interface de test est réalisée en utilisant les données de fabrication de la carte issues de la base de données CAO, abréviation pour "Conception Assistée par Ordinateur", et permet un accès à chaque équipotentielle. Elle est de plus réalisée avant la livraison de la première carte de circuit imprimé nue. Le test in situ n'a pas pour vocation le test des cartes de circuit imprimé nues, mais une modification simple apportée à celles-ci permet de valider leur conformité avec la base de données CAO, la possibilité d'accès aux équipotentielles, l'absence de courts-circuits, sans autres moyens que ceux utilisés pour le test de la carte équipée.

Le test in situ d'une carte 1 est réalisé via des pointes ou sondes 2₁ à 2₃ Chaque sonde, 2₁ à 2₃, représentée respectivement par une flèche en contact avec une plage de test 3₁ à 3₃ de la carte de circuit imprimé 1, est reliée à son autre extrémité au point commun d'un inverseur 4₁ à 4₃ dont les deux autres bornes sont reliées respectivement à un potentiel de référence, par exemple la masse M, et un générateur de courant 5₁ à 5₃. Dans l'exemple de la figure, une première pointe 2₁ est reliée au générateur de courant 5₁ tandis que les deux autres pointes 2₂ et 2₃ sont reliées à la masse M. Le testeur est matérialisé sur cette figure par son interface de test 6. Les pointes 2₁ à 2₃ sont implantées sur l'interface de test 6 et reliées respectivement à des canaux de mesure du testeur non représentés. Lors de la conception du circuit imprimé, il est prévu sur une des faces, un accès à toutes les équipotentielles matérialisées par une pastille de cuivre correspondant respectivement à une plage de test 3₁ à 3₃. Toutes les couches électriques de la carte de circuit imprimé 1 sont reliées, dans le cas de circuits multicouches, par des trous métallisés appelés également "vias" 7₁ à 7₃.

La carte de circuit imprimé nue 1 est considérée bonne, si toutes les plages de test 3₁ à 3₃ sont en contact avec les pointes 2₁ à 2₃ de l'interface de test 6 et s'il n'existe pas de court-circuit entre elles.

La vérification s'effectue habituellement en deux étapes. Dans une première étape, le testeur mesure un courant de l'ordre de 10 à 50 nA, circulant entre chacune des pointes de test en générant pour cela un courant sur l'équipotentielle à tester et en réunissant toutes les autres à la masse. Dans une deuxième étape, sans bouger la carte 1, le testeur mesure la valeur ohmique entre chaque équipotentielle et toutes les autres. Cette valeur doit être inférieure à environ 5 ohms pour conclure qu'aucune équipotentielle n'est en court-circuit.

Le test d'accès aux équipotentielles se fait sans problème sur un circuit imprimé équipé de composants, car la présence des composants favorise la circulation d'un courant entre l'équipotentielle testée et les autres réunies à la masse. En revanche, sur une carte de circuit imprimé nue, aucun courant ne peut circuler du fait de l'absence de continuité entre les équipotentielles.

Le test de recherche de courts-circuits est réalisable sur la carte de circuit imprimé nue ou équipée, mais le résultat ne peut être pris en compte que si le contact avec l'équipotentielle est assuré.

Une modification provisoire apportée sur la carte de circuit imprimé nue 1 permet de réaliser ces deux étapes en une seule manipulation sur le testeur 6. Pour cela, la face 8 de la carte 1, opposée à la face 9 recevant les pointes 3₁ à 3₃ pour le test in situ, est recouverte d'un produit conducteur 10, par exemple un vernis conducteur à base de graphite commercialisé sous le nom de BLINDOTUB, par la société SICERONT KF, présentant une résistance d'environ 1000 Ω/cm².

Toutes les équipotentielles 3₁ à 3₃ sont ainsi réunies par un composant fictif 10. La circulation d'un courant devient alors possible et l'assurance du bon contact entre la pointe 2₁ à 2₃ et l'équipotentielle 3₁ à 3₃ permet de valider l'absence de courts-circuits.

Lorsque la carte de circuit imprimé nue 1 est testée, le produit 10 totalement inoffensif pour les matériaux habituellement déposés sur les cartes peut être retiré avec un solvant approprié et le report des composants peut alors être effectué.

## Revendications

1. Procédé de contrôle de cartes de circuits imprimés, avant le report de composants sur les cartes, consistant à amener les sondes (2₁ à 2₃) d'un testeur (6), utilisé habituellement pour le test des cartes équipées de composants, en contact avec des plages métallisées (3₁ à 3₃) aménagées sur une première face (9) de la carte et couplées à au moins un noeud du circuit imprimé sur la première face (9) de la carte (1), caractérisé en ce qu'il consiste à recouvrir provisoirement la face (8) opposée à la première face (9) recevant les sondes (2₁ à 2₃) d'une couche conductrice (10) permettant d'assurer une liaison électrique entre chacun des noeuds du circuit imprimé sur la carte (1), et après avoir vérifié par le testeur (6) que les plages (3₁ à 3₃) sont en contact avec les sondes (2₁ à 2₃) et qu'il n'y a pas de courts-circuits entre les plages (3₁ à 3₃), à retirer la couche conductrice (10) avant le report des composants sur la carte (1).

2. Procédé selon la revendication 1, caractérisé en ce que pour assurer une liaison électrique entre chacun des noeuds du circuit imprimé sur la carte (1), il consiste à recouvrir la face (8) opposée à la première face (9) de la carte (1) d'un vernis conducteur (10) puis après vérification de la carte (1) à dissoudre ce vernis (10) par un solvant approprié.

3. Système de contrôle de cartes de circuits imprimés, avant le report de composants sur les cartes, comportant un dispositif de test (6) des cartes équipées de composants, muni de sondes (2₁ à 2₃) destinées à être amenées lors du test en contact avec des plages métallisées (3₁ à 3₃) aménagées sur une première face (9) de la carte (1) et couplées à au moins un noeud du circuit imprimé sur la carte (1), caractérisé en ce que la face (8) opposée à la première face (9) de la carte (1) recevant les sondes (2₁ à 2₃), est recouverte d'une couche conductrice destructible (10), permettant d'assurer une liaison électrique provisoire entre chacun des noeuds du circuit imprimé sur la carte (1).

4. Système selon la revendication 3, caractérisé en ce que la couche conductrice (10) est constituée d'un vernis conducteur pouvant être dissout par un dissolvant approprié.

5. Système selon la revendication 4, caractérisé en ce que le vernis conducteur (10) est constitué de graphite et présente une résistance d'environ 1000 Ω/cm².
